(19) Europäisches Patentamt
European Patent Office
Office européen des brevets

(11) **EP 3 080 624 B1**

(12) **FASCICULE DE BREVET EUROPEEN**

(45) Date de publication et mention
de la délivrance du brevet:
**11.03.2020 Bulletin 2020/11**

(21) Numéro de dépôt: **14809878.3**

(22) Date de dépôt: **11.12.2014**

(51) Int Cl.:
**G01R 31/36** *(2020.01)*

(86) Numéro de dépôt international:
**PCT/EP2014/077398**

(87) Numéro de publication internationale:
**WO 2015/086754 (18.06.2015 Gazette 2015/24)**

(54) **PROCEDE D'ESTIMATION DE L'ETAT DE SANTE D'UNE BATTERIE**

VERFAHREN ZUR SCHÄTZUNG DES GESUNDHEITSZUSTANDES EINER BATTERIE

METHOD OF ESTIMATING THE STATE OF HEALTH OF A BATTERY

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **12.12.2013 FR 1362458**

(43) Date de publication de la demande:
**19.10.2016 Bulletin 2016/42**

(73) Titulaire: **Commissariat à l'Énergie Atomique
et aux Énergies Alternatives
75015 Paris (FR)**

(72) Inventeurs:
• **DELAILLE, Arnaud
73000 Bassens (FR)**
• **GROLLEAU, Sébastien
78990 Elancourt (FR)**

(74) Mandataire: **Novaimo
Europa 1
362, avenue Marie Curie
Archamps Technopole
74166 Saint Julien-en-Genevois Cedex (FR)**

(56) Documents cités:
**EP-A1- 2 557 428        EP-A1- 2 579 381
WO-A1-2013/165089**

EP 3 080 624 B1

**Description**

L'invention concerne un procédé d'estimation de l'état de santé d'une batterie. Elle concerne aussi un système de gestion de batterie mettant en œuvre ce procédé d'estimation de l'état de santé d'une batterie.

La gestion des batteries de l'état de la technique fait appel à un indicateur représentatif du vieillissement d'une batterie, souvent appelé par sa dénomination anglo-saxonne de « State Of Health » pour état de santé, ou plus simplement SOH. Cet indicateur est usuellement exprimé en pourcentage de la capacité initiale à l'état neuf de la batterie, capacité mesurée dans cet état initial ou fournie par le fabricant de la batterie. Le SOH est couramment utilisé dans le diagnostic d'une batterie, il est représentatif de l'usure d'une batterie. Son évaluation est importante pour une bonne maîtrise du fonctionnement de la batterie, ainsi que pour gérer au mieux sa fin de vie.

Selon une première approche, la valeur réelle du SOH est mesurée en mettant en œuvre un test de capacité, consistant en une pleine charge puis une pleine décharge successive de la batterie, dans des conditions choisies de température et de courant. Durant cette décharge, la quantité de charges restituée est mesurée, ce qui permet d'en déduire la capacité réelle de la batterie, et donc son SOH. L'avantage de cette méthode est d'obtenir la valeur réelle du SOH, puisqu'elle repose sur une mesure de la réalité. Toutefois, ses inconvénients sont qu'elle nécessite une durée importante, consomme de l'énergie, et nécessite une intervention sur la batterie qui est parfois incompatible avec son utilisation normale, c'est-à-dire de fourniture d'énergie pour la mise en œuvre d'une certaine application concrète : elle nécessite alors une pause de cette application, pour la mise en œuvre du test de la batterie. Pour cette dernière raison, cette première approche est considérée intrusive puisqu'elle nécessite généralement l'arrêt de l'utilisation normale de la batterie.

Pour pallier aux inconvénients de la mesure du SOH réel, d'autres approches moins intrusives existent, qui reposent sur son estimation. A titre d'exemple, une méthode usuelle pour estimer le SOH consiste à suivre l'évolution de la résistance de la batterie, ou par extension suivre un ou plusieurs paramètres d'impédance de la batterie. L'usure d'une batterie s'accompagne en effet généralement d'une évolution de ces paramètres. L'inconvénient de cette méthode est de ne pas mesurer directement la perte de capacité de la batterie, mais de l'estimer à partir de l'évolution d'un paramètre différent. Or, l'évolution des pertes de capacité et des augmentations de résistance, ou d'impédances, ne suivent pas des lois généralisables pour toutes les batteries, ni pour toutes les conditions de vieillissement des batteries. Ainsi, il existe des situations pratiques pour lesquelles l'augmentation de la résistance d'une batterie est parfois négligeable alors que la batterie subit une perte de capacité importante, et inversement. Cette méthode d'estimation reste donc insuffisamment fiable, et souvent complexe car elle nécessite des calculs complémentaires reposant par exemple sur un apprentissage préalable pour tenter de pallier à ses défaillances.

Le document EP2557428 (D1), décrit une solution pour diagnostiquer l'état d'une batterie, notamment une batterie d'un véhicule automobile électrique. Cette solution repose sur le constat de l'évolution des caractéristiques de chaque électrode de la batterie avec son vieillissement.

Ainsi, un objet général de l'invention est de proposer une solution d'estimation du SOH d'une batterie qui ne comprend pas tout ou partie des inconvénients de l'état de la technique.

Plus précisément, un objet de l'invention est de proposer une solution d'estimation du SOH d'une batterie, fiable, rapide, non intrusive.

A cet effet, l'invention repose sur un procédé d'estimation de l'état de santé SOH d'une batterie, caractérisé en ce qu'il comprend les étapes suivantes :

- Mesures de plusieurs valeurs de tension à vide de la batterie pour des états de charge différents ;
- Calcul de paramètres de modèles mathématiques des potentiels à vide de chacune des électrodes de la batterie, pour obtenir une estimation des tensions à vide de la batterie pour les états de charge considérés à l'étape précédente à partir de ces modèles mathématiques, ce calcul de paramètres mettant en œuvre des itérations pour trouver des valeurs extrêmes xmax ; xmin ; ymax ; ymin des taux d'insertion des électrodes de la batterie sur leur plage de fonctionnement, jusqu'à ce que la différence entre les valeurs estimées de tensions à vide et les valeurs mesurées de ces tensions à vide soit inférieure ou égale à un seuil imposé ;
- Calcul de l'état de santé SOH de la batterie à partir des modèles mathématiques des potentiels à vide de chacune des électrodes de la batterie et des paramètres associés à ces modèles mathématiques calculés à l'étape précédente,

cette étape de calcul de l'état de santé de la batterie comprenant le calcul de la capacité Qcell de la batterie par la formule suivante :

$$Qcell = Qneg\ (xmax-xmin)$$

Où Qneg représente la capacité de l'électrode négative,
xmax et xmin représentent les taux d'insertion extrêmes de l'électrode négative sur la plage de fonctionnement de la batterie,

Ou cette étape de calcul de l'état de santé (E3) de la batterie comprenant le calcul de la capacité Qcell de la batterie par la formule suivante :

$$Qcell = Qpos\ (ymax-ymin)$$

Où Qpos représente la capacité de l'électrode positive,
ymax et ymin représentent les taux d'insertion extrêmes de l'électrode positive sur la plage de fonctionnement de la batterie.

L'étape de calcul de paramètres peut comprendre les sous-étapes suivantes :

- initialisation de valeurs extrêmes (xmax ; xmin ; ymax ; ymin) de la plage de fonctionnement des électrodes ;
- calculs des couples de taux d'insertion (xi ; yi) des deux électrodes de la batterie, dans les différents états de charge de la batterie qui ont fait l'objet de l'étape de mesures (E1) ;
- calcul de la tension estimée U aux bornes de la batterie pour les couples (xi ; yi), par la relation U(xi, yi) = OCV+(yi) - OCV-(xi), où les valeurs OCV+(yi) et OCV-(xi) sont calculées à partir d'une modélisation mathématique des tensions à vide des électrodes ;
- comparaison des tensions à vide estimées U calculées pour les couples (xi ; yi) avec les valeurs de tension mesurées à l'étape de mesure, et en cas de différence supérieure à un seuil, correction des valeurs extrêmes (xmax ; xmin ; ymax ; ymin) de la plage de fonctionnement des électrodes et répétition des étapes précédentes.

Les taux d'insertion (xi, yi) des électrodes de la batterie peuvent être définis par :

$$xi = xmax - Qdech\ /\ Qneg$$

$$yi = ymin + Qdech\ /\ Qpos$$

où Qneg représente la capacité de l'électrode négative,
Qpos représente la capacité de l'électrode positive,
Qdech représente la capacité déchargée par rapport à un état de référence complètement chargé de la batterie (xi = xmax et yi = ymin),
Ou
les taux d'insertion (xi, yi) des électrodes de la batterie peuvent être définis par :

$$xi = xmin - Qchargee\ /\ Qneg$$

$$yi = ymax + Qchargee\ /\ Qpos$$

où Qneg représente la capacité de l'électrode négative,
Qpos représente la capacité de l'électrode positive,
Qchargee représente la capacité chargée ou estimée par rapport à un état de référence complètement déchargé de la batterie (xi = xmin et yi = ymax).

La capacité déchargée Qdech peut être calculée, ou estimée à partir de l'état de charge de la batterie.
L'étape de mesures de valeurs de tensions à vide de la batterie peut comprendre la mesure de 2 à 5 valeurs de tension à vide de la batterie, et/ou peut comprendre la répartition de ces mesures sur une plage favorable préalablement définie.
L'étape de mesures de valeurs de tensions à vide de la batterie peut comprendre la réalisation de plusieurs mesures pendant des périodes distinctes de repos de la batterie.

L'invention porte aussi sur un support informatique lisible par une unité de gestion, caractérisé en ce qu'il comprend un programme informatique enregistré comprenant des moyens de codes de programme informatique de mise en œuvre du procédé d'estimation de l'état de santé d'une batterie tel que défini précédemment.

L'invention porte aussi sur un dispositif comprenant au moins une batterie et une unité de gestion, caractérisé en ce que l'unité de gestion met en œuvre un procédé d'estimation de l'état de santé d'au moins une batterie tel que défini précédemment.

La batterie peut être une batterie à base de lithium et/ou le dispositif peut être un véhicule automobile ou un objet portable comme un ordinateur, un téléphone, une tablette ou un agenda électronique.

Ces objets, caractéristiques et avantages de la présente invention seront exposés en détail dans la description suivante d'un mode de réalisation particulier fait à titre non-limitatif en relation avec les figures jointes parmi lesquelles :

La figure 1 représente les courbes de tension à vide des deux électrodes d'une batterie Li-ion C/LFP (graphite / phosphate de fer) neuve en fonction de leur taux d'insertion de lithium.

La figure 2 représente les courbes de tension à vide des deux électrodes d'une même batterie dans un état vieilli.

La figure 3 illustre plusieurs mesures de la tension à vide aux bornes d'une batterie pour plusieurs taux d'insertion de l'électrode négative et pour trois états de vieillissement différents.

La figure 4 illustre l'erreur obtenue dans le calcul du SOH selon le procédé selon un mode de réalisation de l'invention en fonction de la perte de capacité de la batterie.

La figure 5 illustre l'évolution de cette erreur dans le calcul du SOH en fonction du nombre de mesures considérées dans le procédé selon un mode de réalisation de l'invention.

La figure 6 représente schématiquement un organigramme d'un procédé d'estimation de l'état de santé d'une batterie selon un mode de réalisation de l'invention.

Pour faciliter la description de cette invention, les termes potentiel et tension seront utilisés de manière non distincte. De même, le terme batterie englobera la désignation d'éléments de batterie unitaires. Par la suite, le mode de réalisation de l'invention va être détaillé pour une batterie de type Li-ion C/LFP (graphite / phosphate de fer), de manière non limitative. Les modes de réalisation décrits peuvent aisément être adaptés et reproduits sur d'autres types de batteries, fonctionnant sur la base d'autres types de principe chimique.

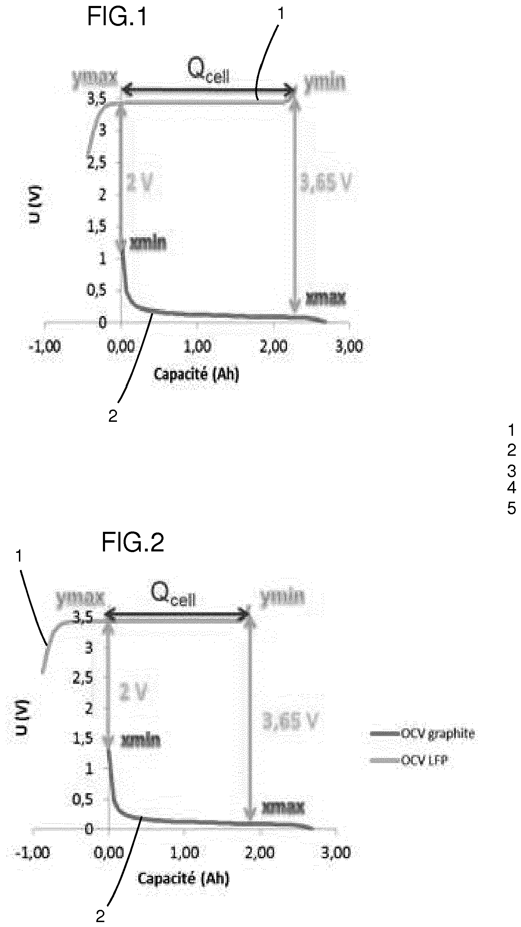

La figure 1 représente la courbe 1 d'évolution de la tension à vide, aussi dénommée OCV pour la dénomination anglo-saxonne de « Open Circuit Voltage », de l'électrode positive de la batterie de type LFP, en fonction de son taux d'insertion y, qui se définit comme le rapport entre la concentration de lithium au niveau de l'électrode et sa concentration maximale dans la batterie. La courbe 2 représente l'évolution de la tension à vide de l'électrode négative de type graphite en fonction de son taux d'insertion x. Ces deux courbes 1, 2 permettent de montrer une plage de fonctionnement de la batterie, définie par leur zone de superposition : cette plage s'étend d'une valeur de taux d'insertion ymax vers une valeur ymin pour l'électrode positive, et d'une valeur de taux d'insertion xmin vers une valeur xmax pour l'électrode négative. Cette plage évolue d'une tension minimale de la batterie, sensiblement à 2V, définie par la différence de potentiel entre les deux électrodes, représentée sur la partie gauche de la figure, correspondant à ymax-xmin, et un état complètement déchargé de la batterie, jusqu'à une tension maximale d'environ 3,65 V, définie par la différence de potentiel entre les deux électrodes, représentée sur la partie droite de la figure, correspondant à ymin-xmax, et un état complètement chargé de la batterie. La capacité Qcell de la batterie est donc la capacité obtenue sur la plage de fonctionnement qui s'étend de ymax à ymin et de xmin à xmax.

La figure 2 représente ces mêmes courbes 1, 2 d'évolution de la tension à vide des électrodes d'une même batterie dans un état vieilli. On constate que la courbe 1 est décalée vers la gauche, ce qui réduit la plage de fonctionnement des deux électrodes. Il en résulte que l'observation de l'évolution de ces courbes illustre bien la diminution de la capacité Qcell maximale de la batterie avec son vieillissement. Sur la figure 2, la capacité maximale présente une valeur inférieure à 2 Ah, donc inférieure à celle obtenue pour la batterie neuve.

En fait, le déplacement de la courbe de tension à vide de l'électrode positive illustre une consommation irréversible de lithium cyclable au niveau de cette électrode avec le temps. Ces courbes 1, 2 illustrent donc des phénomènes physiques de base des électrodes qui expliquent le vieillissement de la batterie. Le mode de réalisation de l'invention tire profit de cette constatation pour mettre au point un procédé d'estimation de l'état de santé d'une batterie qui exploite les courbes de tension à vide de ses électrodes. Comme ces courbes représentent directement le phénomène physique causant le vieillissement, leur analyse permet d'obtenir une valeur fiable de l'état de santé d'une batterie. Plus particulièrement, la recherche du couple (xmax ; ymin) permet de déduire la capacité de la batterie, donc son état de santé.

En remarque, les courbes de potentiel de chacune des électrodes peuvent être mesurées à partir de piles boutons fabriquées à partir d'une partie d'électrode de la batterie étudiée et d'une électrode de lithium métal, configuration dite en demi-pile. Une autre façon de mesurer ces courbes de potentiel de chacune des deux électrodes consiste à avoir recours à une électrode de référence ajoutée au sein d'une cellule complète. A partir de ces mesures réalisées à des courants très faibles, associés à une capacité très faible des demi-piles ou piles avec électrode de référence, de l'ordre de cent fois inférieure à la capacité de la batterie considérée, il est possible de déterminer des modèles empiriques d'évolution de la tension de chacune des électrodes en fonction du taux d'insertion de lithium.

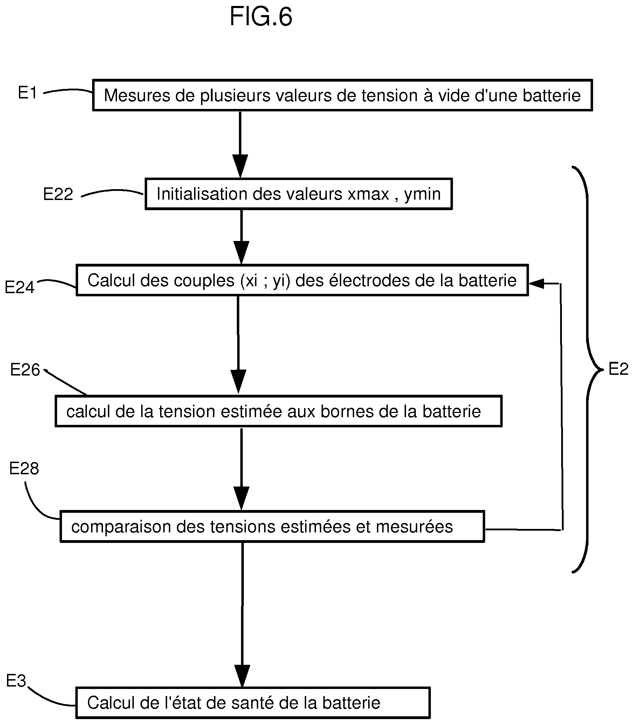

Le procédé d'estimation de l'état de santé d'une batterie selon le mode de réalisation, illustré par la figure 6, met en œuvre les étapes suivantes :

E1 : mesures de plusieurs valeurs de tension à vide d'une batterie pour des états de charge différents ;

E2 : calcul de paramètres de modèles mathématiques des potentiels à vide de chacune des électrodes de la batterie pour obtenir une estimation des tensions à vide de la batterie pour les états de charge considérés à l'étape précédente à partir de ces modèles mathématiques ;

E3 : calcul de l'état de santé de la batterie à partir des modèles des potentiels à vide de chacune des électrodes de la batterie et des paramètres associés à ces modèles calculés à l'étape précédente.

En remarque, la tension à vide d'une batterie est mesurée à l'équilibre, c'est-à-dire hors courant, après relaxation de la tension. Une mesure de tension à vide peut par exemple être obtenue lorsqu'un appareil utilisant la batterie est en veille. En variante, la tension à vide peut être estimée dans des situations d'utilisation à très faible courant de la batterie.

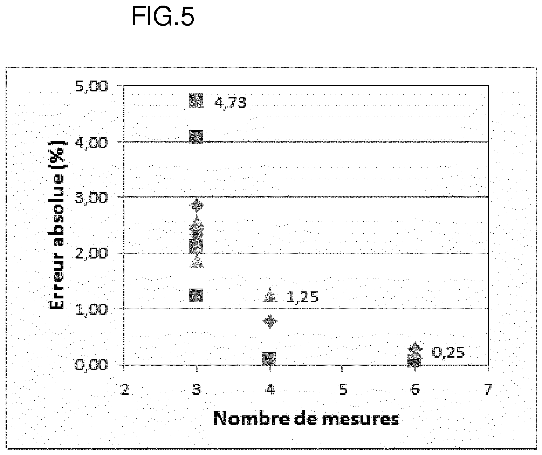

D'autre part, à l'étape E1, un nombre suffisant de mesures de tension à vide est réalisé pour obtenir la fiabilité recherchée. Comme cela est illustré plus bas en référence avec la figure 5, une erreur du SOH inférieure à 5% est atteinte avec deux mesures, et cette erreur tombe sous les 1% à partir de quatre mesures considérées. De plus, comme l'état de santé de la batterie évolue lentement, les mesures de l'étape de mesure E1 peuvent être étalées sur une longue période, par exemple de l'ordre de un mois. Les mesures sont mémorisées dans une mémoire électronique d'une unité de gestion afin d'être exploitées pour la mise en œuvre des autres étapes du procédé.

L'étape de calcul de paramètres E2 permet de déterminer des paramètres de modèles mathématiques de la tension à vide des électrodes, notamment les valeurs extrêmes (xmax ; xmin ; ymax ; ymin) en référence avec les approches illustrées par les figures 1 et 2, et plus particulièrement (xmax ; ymin), à partir desquelles la capacité de la batterie Qcell peut être déduite, puis son état de santé à l'étape E3.

La tension U à vide aux bornes de la batterie est définie par la relation :

$$U = OCV+ - OCV-$$

Où les tensions à vide OCV de chaque électrode, respectivement OCV+ et OCV- pour les électrodes positive et négative, sont obtenues par les modèles mathématiques en fonction de leur taux d'insertion lithium, respectivement x, y.

A titre d'exemple, les modèles mathématiques choisis pour les tensions à vide OCV des électrodes de la batterie considérée dans le mode de réalisation sont par exemple :

Electrode graphite (négative) :

$$OCV\text{-}(x) = 0{,}6379 + 0{,}5416 \cdot \exp(-305{,}5309 \cdot x) - 0{,}0175 \cdot \tanh\left(\frac{(x - 0{,}5692)}{0{,}0875}\right) -$$

$$0{,}6875 \cdot \tanh\left(\frac{(x + 0{,}0117)}{0{,}0529}\right) - 0{,}1978 \cdot \tanh\left(\frac{(x - 1{,}0571)}{0{,}0854}\right) + 0{,}044 \cdot \tanh(-\frac{(x - 0{,}1958)}{0{,}1088})$$

Electrode LiFePO$_4$ (positive) :

$$OCV+(y) = 3{,}4323 - 0{,}8428 \cdot \exp(-80{,}2493(1-y)^{1{,}3198}) - 3{,}2474 \cdot 10^{-6} \exp(20{,}2645(1-y)^{3{,}8003})$$

$$+3{,}2482 \cdot 10^{-6} - 6 \cdot \exp(20{,}2646(1-y)^{3{,}7995})$$

En variante, tout autre modèle permettant de simuler le comportement des électrodes et d'en déduire leur tension à vide OCV pourrait être utilisé.

L'étape de calcul de paramètres E2 peut comprendre les sous-étapes suivantes :

E22 - choix de valeurs initiales des grandeurs xmax et ymin ; ce choix peut consister à prendre les précédentes valeurs calculées, ou en variante ces valeurs légèrement diminuées, par exemple en fonction de l'utilisation de la batterie depuis la dernière mesure ;

E24 - calculs des couples de taux d'insertion (xi ; yi) des deux électrodes de la batterie, correspondant aux différents états de charge qui ont fait l'objet des mesures à l'étape E1. Ces taux d'insertion sont définis par :

$$xi = xmax - Qdech / Qneg$$

$$yi = ymin + Qdech / Qpos$$

où Qneg représente la capacité de l'électrode négative,

Qpos représente la capacité de l'électrode positive,

ces deux capacités Qneg et Qpos ne varient pas avec le temps, sont des constantes bien déterminées, qui peuvent être déterminées par autopsie des cellules ou bien en exploitant une électrode de référence si la batterie en est équipée,

Qdech représente la capacité déchargée par rapport à un état de référence complètement chargé de la batterie. Cette valeur peut être calculée, par exemple à partir de la mesure du courant et son intégration dans le temps, ou en variante estimée, à partir de la connaissance d'une estimation de l'état de charge de la batterie par exemple ;

E26 - calcul de la tension estimée aux bornes de la batterie pour les couples (xi ; yi), par la relation U (xi, yi) = OCV+ (yi) - OCV- (xi), où les valeurs des OCV+ et OCV- sont calculées par la modélisation choisie, par exemple par les formules détaillées précédemment ;

E28 - comparaison des tensions estimées calculées à l'étape précédente pour les couples (xi ; yi) avec les valeurs de tension mesurées à l'étape de mesure E1, et en cas de différence, correction des valeurs de xmax et ymin et répétition des étapes E24 à E28.

En variante, à la sous-étape E24, les taux d'insertion xi, yi des électrodes de la batterie peuvent être définis par :

$$xi = xmin - Qchargee / Qneg$$

$$yi = ymax + Qchargee / Qpos$$

où Qneg représente la capacité de l'électrode négative,

Qpos représente la capacité de l'électrode positive,

Qchargee représente la capacité chargée ou estimée par rapport à un état de référence complètement déchargé de la batterie (xi = xmin et yi = ymax).

Les sous-étapes précédentes permettent donc par itérations successives de converger vers les valeurs de xmax et ymin qui correspondent aux valeurs de tension mesurées, et qui sont retenues pour le calcul de l'état de santé de la batterie. Cette itération est stoppée lorsque l'écart entre les valeurs estimées et mesurées est inférieur ou égal à un seuil choisi. Ce seuil peut être un paramètre du système, défini en fonction d'un compromis entre la précision et la rapidité du calcul. Naturellement, en variante, ces équations peuvent être résolues par toute autre méthode de calcul numérique.

Comme cela ressort des figures 1 et 2, lorsque les courbes OCV des électrodes sont connues, on obtient directement la capacité Qcell de la batterie. Cette capacité peut aussi se calculer par la formule suivante :

$$Qcell = Qneg (xmax-xmin), ou par Qcell = Qpos (ymax-ymin)$$

En remarque, dans le mode de réalisation choisi, xmin reste constant à zéro. Cela pourrait être différent pour d'autres types de batteries.

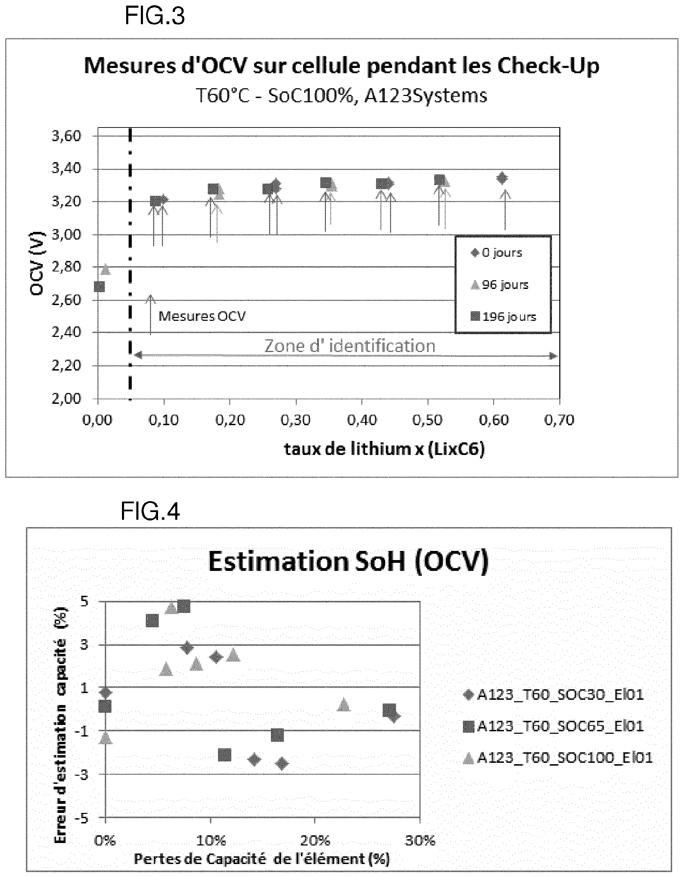

Pour illustrer un exemple d'application de ce procédé, la figure 3 représente plusieurs estimations de la tension aux bornes d'une batterie obtenues pour plusieurs taux d'insertion de l'électrode négative et pour trois états de vieillissement différents, respectivement à 0 jour, 96 jours et 196 jours d'utilisation de la batterie. De préférence, le procédé est mis en œuvre pour des valeurs éloignées des bornes xmax et xmin. Dans cette application, le nombre de valeurs considérées augmente avec le vieillissement.

La figure 4 illustre l'erreur obtenue dans le calcul du SOH par cette méthode selon le mode de réalisation de l'invention, en fonction de la perte de capacité de la batterie. Il apparaît que l'erreur reste inférieure à 5% sur toute la plage considérée.

La figure 5 illustre l'évolution de cette erreur dans le calcul du SOH par cette méthode en fonction du nombre de mesures considérées. Il apparaît que l'erreur descend de manière exponentielle de 5% à moins de 1% dès qu'on considère au moins quatre mesures.

Finalement, le mode de réalisation de l'invention présente les avantages suivants :

- Les calculs mis en œuvre sont simples et donc compatibles avec une implémentation au sein de tout dispositif, comme un objet portable éventuellement de petite taille ; ils ne nécessitent de plus pas la prise en compte du courant ou de la température de la batterie ;
- L'approche est facilement généralisable à tout type de batteries, fonctionnant sur des principes de chimie différents. il suffit d'adapter les modèles mathématiques d'OCV aux électrodes considérées ;
- Le procédé montre en pratique qu'il permet d'atteindre une très grande précision, comme cela a été démontré précédemment ;
- Le procédé est non intrusif, car il peut facilement être mis en œuvre de manière opportuniste, en réalisant des mesures de tension dès que la batterie est dans une période de repos, suffisamment longue pour obtenir une relaxation en tension acceptable, de l'ordre de 30 minutes par exemple, sans déranger le fonctionnement normal de la batterie ;
- Son utilisation est indépendante du fonctionnement en charge ou décharge de la batterie.

En variante, le procédé peut imposer une plage d'états de charge favorable sur laquelle doivent être réalisées les mesures, afin d'éviter la prise en compte de mesures trop proches entre elles, et/ou trop proches des états extrêmes de pleine charge ou pleine décharge. Cette plage peut aussi être établie en fonction de la forme de la courbe d'OCV d'une électrode considérée, afin d'éviter des zones de cette courbe qui seraient défavorables. Les mesures d'OCV peuvent être forcées si on n'atteint pas naturellement les conditions recherchées, à un instant souhaité. Pour cela, un protocole particulier de charge, intégrant des pauses, pourrait par exemple être mis en œuvre pour fournir les conditions avantageuses.

L'invention porte aussi sur un dispositif équipé d'une batterie et comprenant une unité de gestion mettant en œuvre le procédé d'estimation de l'état de santé (SOH) de la batterie tel que décrit précédemment, par des composants matériel et/ou logiciel. Pour cela, l'unité de gestion comprend un calculateur, est associée à au moins une mémoire électronique stockant notamment les données numériques de mesures et les modélisations des OCV d'électrodes, et un logiciel de calcul mettant en œuvre tout ou partie du procédé d'estimation de l'état de santé (SOH). L'invention porte d'ailleurs aussi sur un tel logiciel en tant que tel. Le dispositif comprend aussi une interface homme machine permettant d'informer un utilisateur de l'état de santé de la batterie, et d'interagir avec lui pour définir certains paramètres du procédé. Enfin, le dispositif comprend au moins un capteur de mesure de tension de la batterie relié par un moyen de communication à l'unité de gestion. En remarque, le dispositif de gestion de la batterie, qui met en œuvre le procédé d'estimation de son état de santé, peut être intégré à la batterie elle-même.

A titre d'exemple non limitatif, le procédé d'estimation du SOH peut ainsi être intégré au sein d'un véhicule automobile, notamment un véhicule électrique ou hybride. Il peut aussi être implémenté dans un chargeur de batteries ou plus spécifiquement dans une borne de recharge de véhicules. Il peut aussi être implémenté au sein de tout objet portable, comme un ordinateur portable, une tablette, un téléphone portable, un agenda électronique, etc.).

## Revendications

**1.** Procédé d'estimation de l'état de santé SOH d'une batterie, **caractérisé en ce qu'**il comprend les étapes suivantes :

> • Mesures (E1) de plusieurs valeurs de tension à vide de la batterie pour des états de charge différents ;
> • Calcul de paramètres (E2) de modèles mathématiques des potentiels à vide de chacune des électrodes de la batterie, pour obtenir une estimation des tensions à vide de la batterie pour les états de charge considérés à l'étape précédente à partir de ces modèles mathématiques, ce calcul de paramètres (E2) mettant en œuvre des itérations pour trouver des valeurs extrêmes xmax ; xmin ; ymax ; ymin des taux d'insertion des électrodes de la batterie sur leur plage de fonctionnement, jusqu'à ce que la différence entre les valeurs estimées de tensions à vide et les valeurs mesurées de ces tensions à vide soit inférieure ou égale à un seuil imposé ;
• Calcul de l'état de santé SOH (E3) de la batterie à partir des modèles mathématiques des potentiels à vide de chacune des électrodes de la batterie et des paramètres associés à ces modèles mathématiques calculés à l'étape précédente, cette étape de calcul de l'état de santé (E3) de la batterie comprenant le calcul de la capacité Qcell de la batterie par la formule suivante :

$$Qcell = Qneg\ (xmax\text{-}xmin)$$

Où Qneg représente la capacité de l'électrode négative,
xmax et xmin représentent les taux d'insertion extrêmes de l'électrode négative sur la plage de fonctionnement de la batterie,
Ou
cette étape de calcul de l'état de santé (E3) de la batterie comprenant le calcul de la capacité Qcell de la batterie par la formule suivante :

$$Qcell = Qpos\ (ymax\text{-}ymin)$$

Où Qpos représente la capacité de l'électrode positive,
ymax et ymin représentent les taux d'insertion extrêmes de l'électrode positive sur la plage de fonctionnement de la batterie.

2. Procédé d'estimation de l'état de santé d'une batterie selon la revendication précédente, **caractérisé en ce que** l'étape de calcul de paramètres (E2) comprend les sous-étapes suivantes :

(E22) - initialisation de valeurs extrêmes xmax ; xmin ; ymax ; ymin des taux d'insertion de la plage de fonctionnement des électrodes ;
(E24) - calculs des couples de taux d'insertion xi ; yi des deux électrodes de la batterie, dans les différents états de charge de la batterie qui ont fait l'objet de l'étape de mesures (E1) ;
(E26) - calcul de la tension estimée U aux bornes de la batterie pour les couples xi, yi par la relation U(xi, yi) = OCV+(yi) - OCV-(xi), où les valeurs OCV+(yi) et OCV-(xi) sont calculées à partir d'une modélisation mathématique des tensions à vide des électrodes ;
(E28) - comparaison des tensions à vide estimées U calculées pour les couples xi, yi avec les valeurs de tension mesurées à l'étape de mesure (E1), et en cas de différence supérieure à un seuil, correction des valeurs extrêmes xmax ; xmin ; ymax ; ymin de la plage de fonctionnement des électrodes et répétition des étapes (E24), (E26) et (E28).

3. Procédé d'estimation de l'état de santé d'une batterie selon la revendication précédente, **caractérisé en ce que** les taux d'insertion xi, yi des électrodes de la batterie sont définis par :

$$xi = xmax - Qdech\ /\ Qneg$$

$$yi = ymin + Qdech\ /\ Qpos$$

où Qneg représente la capacité de l'électrode négative,
Qpos représente la capacité de l'électrode positive,
Qdech représente la capacité déchargée par rapport à un état de référence complètement chargé de la batterie (xi = xmax et yi = ymin),
Ou
**en ce que** les taux d'insertion xi, yi des électrodes de la batterie sont définis par :

$$xi = xmin - Qchargee / Qneg$$

$$yi = ymax + Qchargee / Qpos$$

où Qneg représente la capacité de l'électrode négative,
Qpos représente la capacité de l'électrode positive,
Qchargee représente la capacité chargée ou estimée par rapport à un état de référence complètement déchargé de la batterie (xi = xmin et yi = ymax).

4. Procédé d'estimation de l'état de santé d'une batterie selon la revendication précédente, **caractérisé en ce que** la capacité déchargée Qdech est calculée, ou estimée à partir de l'état de charge de la batterie.

5. Procédé d'estimation de l'état de santé d'une batterie selon l'une des revendications précédentes, **caractérisé en ce que** l'étape de mesures (E1) de valeurs de tensions à vide de la batterie comprend la mesure de 2 à 5 valeurs de tension à vide de la batterie, et/ou comprend la répartition de ces mesures sur une plage favorable préalablement définie.

6. Procédé d'estimation de l'état de santé d'une batterie selon l'une des revendications précédentes, **caractérisé en ce que** l'étape de mesures (E1) de valeurs de tensions à vide de la batterie comprend la réalisation de plusieurs mesures pendant des périodes distinctes de repos de la batterie.

7. Support informatique lisible par une unité de gestion, **caractérisé en ce qu'**il comprend un programme informatique enregistré comprenant des moyens de codes de programme informatique de mise en œuvre du procédé d'estimation de l'état de santé d'une batterie selon l'une des revendications précédentes.

8. Dispositif comprenant au moins une batterie et une unité de gestion, **caractérisé en ce que** l'unité de gestion met en œuvre un procédé d'estimation de l'état de santé d'au moins une batterie selon l'une des revendications 1 à 6.

9. Dispositif selon la revendication précédente, **caractérisé en ce que** la batterie est une batterie à base de lithium et/ou **en ce que** le dispositif est un véhicule automobile ou un objet portable comme un ordinateur, un téléphone, une tablette ou un agenda électronique.

**Patentansprüche**

1. Verfahren zur Schätzung des Gesundheitszustands SOH einer Batterie, **dadurch gekennzeichnet, dass** es die folgenden Schritte umfasst:

• Messungen (E1) mehrerer Leerlaufspannungswerte der Batterie für verschiedene Ladungszustände;
• Berechnung von Parametern (E2) mathematischer Modelle von Leerlaufpotentialen jeder der Elektroden der Batterie, um eine Schätzung von Leerlaufspannungen der Batterie für die Ladungszustände, die im vorhergehenden Schritt berücksichtigt wurden, aus diesen mathematischen Modellen zu erhalten, wobei diese Berechnung von Parametern (E2) Iterationen verwendet, um Extremwerte xmax; xmin; ymax; ymin von Insertionsraten der Elektroden der Batterie in ihrem Betriebsbereich zu finden, bis die Differenz zwischen den geschätzten Werten der Leerlaufspannungen und den gemessenen Werten dieser Leerlaufspannungen kleiner oder gleich einer vorgegebenen Schwelle ist;
• Berechnung des Gesundheitszustands SOH (E3) der Batterie aus den mathematischen Modellen der Leerlaufpotentiale jeder der Elektroden der Batterie und den in dem vorhergehenden Schritt berechneten Parametern, die mit diesen mathematischen Modellen assoziiert sind,
wobei dieser Schritt der Berechnung des Gesundheitszustands (E3) der Batterie die Berechnung der Kapazität Qcell der Batterie durch die folgende Formel umfasst:

```
Qcell = Qneg (xmax-xmin),
```

wobei Qneg die Kapazität der negativen Elektrode darstellt,
xmax und xmin die extremen Insertionsraten der negativen Elektrode in dem Betriebsbereich der Batterie darstellen,
oder
wobei dieser Schritt der Berechnung des Gesundheitszustands (E3) der Batterie die Berechnung der Kapazität Qcell der Batterie durch die folgende Formel umfasst:

$$Qcell = Qpos\ (ymax-ymin)$$

wobei Qpos die Kapazität der positiven Elektrode darstellt,
ymax und ymin die extremen Insertionsraten der positiven Elektrode in dem Betriebsbereich der Batterie darstellen.

2. Verfahren zur Schätzung des Gesundheitszustands einer Batterie nach dem vorhergehenden Anspruch, **dadurch gekennzeichnet, dass** der Schritt der Berechnung der Parameter (E2) die folgenden Teilschritte umfasst:

(E22) - Initialisierung von Extremwerten xmax; xmin; ymax; ymin der Insertionsraten des Betriebsbereichs der Elektroden;
(E24) - Berechnungen der Paare von Insertionsraten xi; yi von zwei Elektroden der Batterie, in den verschiedenen Ladungszuständen der Batterie, die Gegenstand des Messschritts (E1) waren;
(E26) - Berechnung der geschätzten Spannung U an den Anschlüssen der Batterie für die Paare xi, yi durch die Beziehung U(xi, yi) = OCV+(yi) - OCV-(xi), wobei die Werte OCV+(yi) und OCV-(xi) aus einer mathematischen Modellerstellung von Leerlaufspannungen der Elektroden berechnet werden;
(E28) - Vergleich der geschätzten Leerlaufspannungen U, die für die Paare xi, yi berechnet wurden, mit den in dem Messschritt (E1) gemessenen Spannungswerten, und im Fall einer Differenz, die größer ist als eine Schwelle, Korrektur der Extremwerte xmax; xmin; ymax; ymin des Betriebsbereichs der Elektroden und Wiederholung der Schritte (E24), (E26) und (E28).

3. Verfahren zur Schätzung des Gesundheitszustands einer Batterie nach dem vorhergehenden Anspruch, **dadurch gekennzeichnet, dass** die Insertionsraten xi, yi der Elektroden der Batterie definiert werden durch:

$$xi = xmax - Qdech\ /\ Qneg$$

$$yi = ymin + Qdech\ /\ Qpos$$

wobei Qneg die Kapazität der negativen Elektrode darstellt,
Qpos die Kapazität der positiven Elektrode darstellt,
Qdech die entladene Kapazität in Bezug auf einen vollständig geladenen Referenzzustand der Batterie (xi = xmax und yi = ymin) darstellt,
oder
dadurch, dass die Insertionsraten xi, yi der Elektroden der Batterie definiert werden durch:

$$xi = xmin - Qchargee\ /\ Qneg$$

$$yi = ymax + Qchargee\ /\ Qpos$$

wobei Qneg die Kapazität der negativen Elektrode darstellt,
Qpos die Kapazität der positiven Elektrode darstellt,
Qchargee die geladene oder geschätzte Kapazität in Bezug auf einen vollständig entladenen Referenzzustand der Batterie (xi = xmin und yi = ymax) darstellt.

4. Verfahren zur Schätzung des Gesundheitszustands einer Batterie nach dem vorhergehenden Anspruch, **dadurch**

**gekennzeichnet, dass** die entladene Kapazität Qdech aus dem Ladungszustand der Batterie berechnet oder geschätzt wird.

5. Verfahren zur Schätzung des Gesundheitszustands einer Batterie nach einem der vorhergehenden Ansprüche, **dadurch gekennzeichnet, dass** der Messschritt (E1) der Leerlaufspannungswerte der Batterie die Messung von 2 bis 5 Leerlaufspannungswerten der Batterie umfasst, und/oder die Verteilung dieser Messungen in einem zuvor definierten vorteilhaften Bereich umfasst.

6. Verfahren zur Schätzung des Gesundheitszustands einer Batterie nach einem der vorhergehenden Ansprüche, **dadurch gekennzeichnet, dass** der Messschritt (E1) der Leerlaufspannungswerte der Batterie die Durchführung mehrerer Messungen während bestimmter Ruheperioden der Batterie umfasst.

7. Von einer Steuereinheit lesbarer Datenträger, **dadurch gekennzeichnet, dass** er ein gespeichertes Datenprogramm umfasst, das Datenprogramm-Codemittel zur Durchführung des Verfahrens zur Schätzung des Gesundheitszustands einer Batterie nach einem der vorhergehenden Ansprüche umfasst.

8. Vorrichtung, umfassend mindestens eine Batterie und eine Steuereinheit, **dadurch gekennzeichnet, dass** die Steuereinheit ein Verfahren zur Schätzung des Gesundheitszustands mindestens einer Batterie nach einem der Ansprüche 1 bis 6 durchführt.

9. Vorrichtung nach dem vorhergehenden Anspruch, **dadurch gekennzeichnet, dass** die Batterie eine Batterie auf der Basis von Lithium ist, und/oder dadurch, dass die Vorrichtung ein Kraftfahrzeug oder ein tragbares Objekt wie ein Computer, ein Telefon, ein Tablet oder ein Organizer ist.

**Claims**

1. Method for estimating the state of health SOH of a battery, **characterized in that** it comprises the following steps:

   • measuring (E1) a plurality of open-circuit voltage values of the battery for different states of charge;
   • computing (E2) parameters of mathematical models of the open-circuit potentials of each of the electrodes of the battery, in order to obtain an estimation of the open-circuit voltages of the battery for the states of charge considered in the preceding step from these mathematical models, this computation (E2) of parameters implementing iterations in order to find extreme values xmax; xmin; ymax; ymin of the degrees of insertion of the electrodes of the battery in the operating range thereof, until the difference between the estimated open-circuit voltage values and the measured values of these open-circuit voltages is smaller than or equal to a set threshold;
   • computing (E3) the state of health SOH of the battery from the mathematical models of the open-circuit potentials of each of the electrodes of the battery and from the parameters associated with these mathematical models computed in the preceding step, this step (E3) of computing the state of health of the battery comprising computing the capacity Qcell of the battery using the following formula:

$$Qcell = Qneg\ (xmax-xmin)$$

   where Qneg is the capacity of the negative electrode,
   and where xmax and xmin are the extreme degrees of insertion of the negative electrode in the operating range of the battery,
   or
   this step (E3) of computing the state of health of the battery comprising computing the capacity Qcell of the battery using the following formula:

$$Qcell = Qpos\ (ymax-ymin)$$

   where Qpos is the capacity of the positive electrode,
   and where ymax and ymin are the extreme degrees of insertion of the positive electrode in the operating range of the battery.

2. Method for estimating the state of health of a battery according to the preceding claim, **characterized in that** the step (E2) of computing comprises the following substeps:

> (E22) - initializing extreme values xmax; xmin; ymax; ymin of the degrees of insertion of the operating range of the electrodes;
> (E24) - computing pairs of degrees of insertion xi; yi of the two electrodes of the battery, in the various states of charge of the battery that were considered in the measuring step (E1);
> (E26) - computing the estimated voltage U across the terminals of the battery for the pairs xi, yi using the relationship U(xi, yi) = OCV+(yi) - OCV-(xi), where the values OCV+(yi) and OCV-(xi) are computed using a mathematical model of the open-circuit voltages of the electrodes;
> (E28) - comparing the estimated open-circuit voltages U computed for the pairs xi, yi with the voltage values measured in the measuring step (E1), and in case of a difference larger than a threshold, correcting the extreme values xmax; xmin; ymax; ymin of the operating range of the electrodes and repeating steps (E24), (E26) and (E28).

3. Method for estimating the state of health of a battery according to the preceding claim, **characterized in that** the degrees of insertion xi, yi of the electrodes of the battery are defined by:

$$xi = xmax - Qdisch / Qneg$$

$$yi = ymin - Qdisch / Qpos$$

where Qneg is the capacity of the negative electrode, Qpos is the capacity of the positive electrode,
Qdisch is the discharged capacity with respect to a completely charged reference state of the battery (xi = xmax and yi = ymin),
or
**in that** the degrees of insertion xi, yi of the electrodes of the battery are defined by:

$$xi = xmin - Qcharged / Qneg$$

$$yi = ymax - Qcharged / Qpos$$

where Qneg is the capacity of the negative electrode,
Qpos is the capacity of the positive electrode,
Qcharged is the charged or estimated capacity with respect to a completely discharged reference state of the battery (xi = xmin and yi = ymax).

4. Method for estimating the state of health of a battery according to the preceding claim, **characterized in that** the discharged capacity Qdisch is computed, or estimated, from the state of charge of the battery.

5. Method for estimating the state of health of a battery according to one of the preceding claims, **characterized in that** the step (E1) of measuring open-circuit voltage values of the battery comprises measuring from 2 to 5 open-circuit voltage values of the battery, and/or comprises distributing these measurements over a favourable range defined beforehand.

6. Method for estimating the state of health of a battery according to one of the preceding claims, **characterized in that** the step (E1) of measuring open-circuit voltage values of the battery comprises carrying out a plurality of measurements during separate periods of rest of the battery.

7. Data medium readable by a management unit, **characterized in that** it comprises a stored computer program comprising computer program code for implementing the method for estimating the state of health of a battery according to one of the preceding claims.

8.  Device comprising at least one battery and a management unit, **characterized in that** the management unit implements a method for estimating the state of health of at least one battery according to one of Claims 1 to 6.

9.  Device according to the preceding claim, **characterized in that** the battery is a battery based on lithium and/or **in that** the device is a motor vehicle or a portable object such as a computer, a telephone, a tablet or a personal digital assistant.

## FIG.1

## FIG.2

## FIG.3

**Mesures d'OCV sur cellule pendant les Check-Up**

T60°C - SoC100%, A123Systems

## FIG.4

**Estimation SoH (OCV)**

## FIG.5

# FIG.6

E1 — Mesures de plusieurs valeurs de tension à vide d'une batterie

E22 — Initialisation des valeurs xmax , ymin

E24 — Calcul des couples (xi ; yi) des électrodes de la batterie

E26 — calcul de la tension estimée aux bornes de la batterie

E28 — comparaison des tensions estimées et mesurées

E2

E3 — Calcul de l'état de santé de la batterie

**EP 3 080 624 B1**

## RÉFÉRENCES CITÉES DANS LA DESCRIPTION

**Documents brevets cités dans la description**

- EP 2557428 D1